(19) Europäisches Patentamt
European Patent Office
Office européen des brevets

(11) Veröffentlichungsnummer: **0 000 743**
**B1**

(12) # EUROPÄISCHE PATENTSCHRIFT

(21) Anmeldenummer: **78100525.1**

(22) Anmeldetag: **27.07.78**

(51) Int. Cl.³: **H 01 L 21/285,**
H 01 L 29/40,
H 01 L 21/60,
H 01 L 23/48

(54) **Verfahren zum Herstellen von Tantal-Kontakten auf einem aus N-leitendem Silicium bestehenden Halbleitersubstrat**

(30) Priorität: **06.08.77 US 827912**

(43) Veröffentlichungstag der Anmeldung:
**21.02.79 Patentblatt 79/04**

(45) Bekanntmachung des Hinweises auf die Patenterteilung:
**17.09.80 Patentblatt 80/19**

(84) Benannte Vertragsstaaten:
**BE DE FR GB**

(56) Entgegenhaltungen:
**DE - A - 2 029 236**
**DE - A - 2 104 672**
**FR - A - 2 324 124**
**US - A - 3 662 458**
**US - A - 3 900 944**
**US - A - 3 906 540**

**IBM TECHNICAL DISCLOSURE BULLETIN, vol. 16, April 1974, New York, T.M. REITH et al. "Al/Pt Si Schottky Barrier Diodes with a diffusion Barrier", Seite 3586.**
**IBM TECHNICAL DISCLOSURE BULLETIN, vol. 14, April 1972, New York, M. REVITZ et al: "Metallurgy barrier for Au and Pb", Seite 3358.**

(73) Patentinhaber: **International Business Machines Corporation**
**Armonk, N.Y. 10504 (US)**

(72) Erfinder: **Dalal, Hormazdyar Minocher**
**66 Amherst Lane**
**Wappingers Falls N.Y. 12590 (US)**
**Ghafghaichi, Majid**
**352 Vassar Road**
**Poughkeepsie N.Y. 12603 (US)**
**Kasprzak, Lucian Alexander**
**Mountain Pass Road and Geneva Drive**
**Hopewell Junction N.Y. 12533 (US)**
**Wimpfheimer, Hans**
**4 Lincoln Drive**
**Poughkeepsie N.Y. 12601 (US)**

(74) Vertreter: **Böhmer, Hans Erich, Dipl.-Ing.**
**Schönaicher Strasse 220**
**D - 7030 Böblingen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

**EP 0 000 743 B1**

# Verfahren zum Herstellen von Tantal-Kontakten auf einem aus N-leitendem Silicium bestehenden Halbleitersubstrat

Die Erfindung betrifft ein Verfahren zum Herstellen von Tantal-Kontakten auf einem aus N-leitenden Silicium bestehenden Halbleitersubstrat, insbesondere zur Bildung von Schottky-Sperrschichtkontakten mit niedriger Potentialschwelle, durch Niederschlagen einer Tantalschicht unter vorgegebenen Bedingungen auf einem zuvor durch Ätzung gereinigten Teil der Oberfläche des Substrats mittels Elektronenstrahlverdampfung oder Hochfrequenz-Kathodenzerstäubung bei niedrigem Druck und niedriger Temperatur zur Vermeidung einer Oxidation des Tantals und Sinterung des Substrats für eine solche Zeit und bei einer solchen Temperatur, daß dabei die zwischen Substratoberfläche und Tantalschicht vorhandenen Grenzflächenladungen entfernt werden, und durch Niederschlagen einer Chromschicht über der Tantalschicht und einer Aluminiumschicht über der Chromschicht, wobei das aus der Schichtenfolge Tantal-Chrom-Aluminium bestehende Muster durch ein Ablöseverfahren definiert wird. Ein Verfahren zum Herstellen von Tantal-Kontakten auf einem aus N-leitendem Silicium bestehenden Halbleitersubstrat zur Bildung von Schottky-Sperrschichtkontakten durch Niederschlagen einer Tantalschicht unter vorgegebenen Bedingungen unmittelbar auf einem zuvor gereimgten Teil der Oberfläche des Substrats mittels Hochfrequenz-Kathodenzerstäubung und Sinterung des Substrats ist aus der DE—A 2 029 236 bekannt.

Die Anforderungen an ein Material oder an eine Kombination von Materialien für ohmsche oder Schottky-Kontakte an halbleitersubstrate sind vom elektrischen und auch vom chemischen Standpunkt aus außerordentlich streng.

Zahlreiche beim Entwurf von Halbleiterschaltungen bekannte metallurgische Systeme wurden als ohmsche Kontakte und als Schottky-Sperrschichtdioden-Kontakte vorgeschlagen und benutzt. Das wohl am meisten und mit dem größten Erfolg bei Metallissierungsverbindungen von Silicium-Planartransistoren und integrierten Schaltungen verwendete Metall ist Aluminium oder mit einer geringen Menge Kupfer dotiertes Aluminium. Mit Aluminium lassen sich an Silicium und den umgebenden Isolierschichten gute ohmsche und mechanische Kontakte herstellen. Aluminium kann durch Verdampfung oder Kathodenzerstäubung leicht niedergeschlagen werden und läßt sich durch Ätzung oder ähnliche Verfahren leicht zu Leitungsmustern umwandeln.

Während der Verarbeitung, insbesondere bei hohen Temperaturen, zeigt Aluminium jedoch eine Neigung, mit Silicium zu reagieren. Außerdem bildet Aluminium zusammen mit Silicium keine Schottky-Sperrschichtkontakte, weder mit hoher Potentialschwelle, noch mit niedriger Potentialschwelle.

In der Literatur findet man eine große Zahl anderer metallurgischer Systeme, die eine oder mehrere Funktionen metallischer Kontakte erfüllen. Wohl das erfolgreichste System dieser Art ist eine Titan-Wolfram-Legierung, die in der Industrie weitgehende Anwendung als Sperrschicht zwischen Aluminium und Silicium gefunden hat. Es ist jedoch nicht möglich, eine Titan-Wolfram-Legierung auf ein Halbleitersubstrat aufzudampfen. Sie muß vielmehr durch Kathodenzerstäubung aufgebracht werden. Diese Legierung kann ebensowenig durch ein Ablöseverfahren zu einem Muster umgestaltet werden.

Bei der Herstellung von Schottky-Sperrschichtdioden ist es zum Beispiel aus der US—PS 3 906 540 bekannt, auf der Oberfläche eines aus N-leitendem Silicium bestehenden Halbleiterkörpers vor dem Niederschlagen einer Tantalschicht ein metallisches Silicid, z.B. PtSi, zu bilden und den Halbleiter körper nach Aufbringen der Tantalschicht zu sintern, um Verunreinigungsschichten zwischen der Substrat oberfläche und der Tantalschicht zu entfernen. Auf der Metallschicht wird nach dem Sintern eine aus Aluminium bestehende Schicht niedergeschlagen.

Auch die Vorreinigung der Substratoberfläche vor Aufbringen einer aus Ta bestehenden Kontaktschicht zur Herstellung ohmscher Kontakte ist bereits aus US—PS 3 900 944 bekannt.

Ferner ist es bei einer Al/PtSi-Schottky-Sperrschichtdiode aus IBM Technical Disclosure Bulletin, Band 16, Nr. 11, April 1974, Seite 3586, bekannt, zwischen der PtSi-Schicht und der Aluminiumschicht eine aus Chrom bestehende Diffusions-Sperrschicht für Aluminium anzuordnen, da sich sonst die intermetallische Verbindung $PtAl_2$ und freies Silicium bilden würden. Ähnliche Verhältnisse liegen auch bei Tantal-Kontakten vor.

Seit einiger Zeit bestand Bedarf nach einer Schottky-Sperrschichtdiode mit einer geringen Potentialschwelle von beispielsweise 0,5 eV. Beispielsweise ist es bei Dioden-Transistor-Logik (DTL) erwünscht, daß die Potentialschwelle der Eingangsdioden bei etwa 0,5 eV liegt. Insbesondere die unter der Kurzbezeichnung $C^3L$ bekannte DTL-Schaltung ist dann besonders brauchbar, wenn Schottky-Dioden, die eingangsseitig als UND-Glied arbeiten, diese Potentialschwelle aufweisen. Die $C^3L$-Schaltung ist beispielsweise in einer Veröffentlichung von A. W. Peltier mit dem Titel "Advances in Solid-State Logic — A New Approach to Bipolar LSI: $C^3L$" in 1975 IEEE International Solid-State Circuits Conference, Digest of Technical Papers, Seiten 168—169, beschrieben. Peltier gibt dabei an, daß entweder Titan, Wolfram oder Titan-Wolfram-Legierungen diese Forderung erfüllen. Diese

Kontakte haben jedoch die bereits oben besprochenen Nachteile.

Aufgabe der Erfindung ist es also, ein Verfahren zum Herstellen von Tantal-Kontakten der oben genannten Art aus einem verbesserten einzigen metallurgischen System anzugeben, das sich sowohl für ohmsche Kontakte als auch für Schottky-Sperrschichtkontakte mit hoher und mit niedriger Potentialschwelle eignet. Vorzugsweise soll das dafür angewandte Verfahren zum Niederschlag von Tantal-Schichten für die Bildung von Schottky-Sperrschichtkontakten mit niedriger Potentialschwelle geeignet sein, wobei gleichzeitig die Verträglichkeit mit den aus Aluminium bestehenden Verbindungsleitungen sichergestellt werden soll.

Diese der Erfindung zugrunde liegende Aufgabe wird dadurch gelöst, daß bei dem Verfahren der eingangs genannten Art die Reinigung der Oberfläche des Silizium substrats mit einer verdünnten Flußsäure-Ätz lösung unter solchen Arbeitsbedingungen durchgeführt wird, daß kein Licht mit einer Wellenlänge von weniger als 500 nm auftritt, daß dann die Tantalschicht durch Elektroneustrahlverdampfung im Vakuum bei einem Verdampfungsdruck von nöchstens $3.333 \times 10^{-6}$ bei einem Anfangs-Verdampfungsdruck von weniger als $5.333 \times 10^{-7}$ mbar und einer Substrattemperatur von höchstens 200°C aufgebracht wird, und daß während der Verdampfung des Chroms Wasserdampf in die Verdampfungs Kammer eingeleitet wird, um an den Korngrenzen Chromoxid zu bilden.

Man erzielt dadurch eine Potentialschwelle von 0,5 eV. Während ausgiebiger Spannungsprüfungen bleibt die Diode außergewöhnlich stabil.

Durch Reinigen des Silicium-substrats in wässeriger Flußsäure unter genau überwachten Strahlungsbedingungen, d.h. daß kein Licht mit einer Wellenlänge von weniger als 500 nm auftritt, vor Niederschlagen des Tantals wird die Bildung von amorphem Silicium auf dieser Oberfläche verhindert. Durch das Niederschlagen des Tantals im Vakuum bei niedrigem Druck von höchstens $3{,}333 \times 10^{-6}$mbar und niedriger Substrattemperatur von höchstens 200°C wird eine Oxidation des Tantals vermieden Da Aluminium als Leitungsmetallisierung verwendet werden soll, muß zwischen der Tantalschicht und der Aluminiumschicht eine Chromschicht als Diffusionssperre niedergeschlagen werden. Die Chromschicht wird dadurch gebildet, daß während der Verdampfung oder der Kathodenzerstäubung von elementarem Chrom ein Wasserdampf eingeleitet wird. Die Langzeitzuverlässigkeit dieses metallurgischen Systems ist außergewöhnlich gut. Besondere Ausführungsarten der Erfindung sind in den Ansprüchen 2 und 3 gekennzeichnet.

Eine auf diese Weise niedergeschlagene Tantalschicht eignet sich einmal als ohmscher Kontakt dann, wenn sie auf der Oberseite einer in $N^+$-leitendem Silicium gebildeten Metall-Silicid-Schicht aufgetragen wird und auch als Schottky-Sperrschichtdiode (SBD) mit hoher Potentialschwelle, wenn die Schicht auf der Oberseite einer in N-leitenden Silicium gebildeten metallischen Silicid-Schicht niedergeschlagen wird.

Die Erfindung wird nunmehr anhand von Ausführungsbeispielen in Verbindung mit den beigefügten Zeichnungen im einzelnen beschrieben.

Dabei zeigen

Fig. 1 in den Teilfiguren 1A—1F Teilschnittansichten einer Halbleitervorrichtung während der verschiedenen Fertigungsverfahrenschritte,

Fig. 2 ein Diagramm der Veränderung der Durchlaßspannung über der Zeit unter Belastung einer Chrom-Tantal-Schottky-Sperrschichtdiode im Vergleich mit einer Tantal-Sperrschichtdiode, wenn Aluminium darauf niedergeschlagen ist,

Fig. 3 ein Diagramm der Durchlaß-Stromspannungskennlinien von gemäß der Erfindung hergestellten Schottky-Sperrschichtdioden mit niedriger und hoher Potentialschwelle,

Fig. 4 eine logische DTL-Schaltung und

Fig. 5 eine Querschnittsansicht einer Halbleiterschaltung mit Schottky-Sperrschichtdioden.

Die Teil-Fig. 1A zeigt den Teil eines Halbleiterplättchens, welcher die erfindungsgemäß hergestellten Schottky-Sperrschichtdioden enthalten soll. Es ist einleuchtend, daß normalerweise innerhalb des gleichen Halbleiterplättchens tausende solcher Dioden und anderer Halbleitervorrichtungen, wie zum Beispiel Transistoren, Widerstände usw. angeordnet sein können. Das Substrat des Halbleiterplättchens besteht beispielsweise aus P-leitendem Silicium, das einen spezifischen Widerstand von 10 Ohm-cm aufweist. Auf diesem Substrat 1 ist eine $N^-$-leitende Schicht 3 angebracht, die vorzugsweise eine Leitfähigkeit von $1 \times 10^{16}$ bis $8 \times 10^{16}$ Atome/cm$^3$ aufweist. In dem Substrat sind zwei vergrabene Zonen 4 und 6 vorgesehen, die über Anschlußzonen 5 und 7 an die Oberfläche des Substrats herausgeführt sind. Das Substrat enthält außerdem ein $P^+$-leitende Subisolationszone 2, die in Verbindung mit einer $P^+$-leitenden Isolationszone 8 die $N^+$-leitenden Zonen gegeneinander abtrennt.

Die Zonen 2, 4 und 6 werden vorteilhafterweise durch Eindiffundieren dieser Zonen durch Öffnungen hergestellt, die in der Oberfläche des Substrats bedeckenden Schicht vorgesehen sind. Ein eine $N^+$-Leitung hervorrufendes Störelement ist Arsen oder Phosphor, ein eine $P^+$-Leitfähigkeit hervorrufendes Störelement ist Bor.

Die Maskenschicht wird dann durch übliche Ätzver-fahren vom Substrat 1 abgezogen, und es wird dabei epitaxial eine Schicht 3 aufgewachsen, wobei die Zonen 2, 4 und 6 durch Ausdiffusion in die Schicht 3 eindringen. Eine

Maskenschicht, die normalerweise aus einer Siliciumdioxid-Schicht 9 und einer Siliciumnitrid-Schicht 10 zusammengesetzt, wird dann auf der Oberfläche der Schicht 3 gebildet und in dieser zusammengesetzten Maskenschicht werden dann Öffnungen hergestellt, durch die die eine $N^+$-Leitfähigkeit bzw. $P^+$-Leitfähigkeit erzeugenden Störelemente zur Bildung der Kontaktzonen 5 und 7 bzw. der Isolationszone 8 eindiffundiert werden.

Anschließand wird dann, alles überdeckend, auf der Siliciumnitrid-Schicht und innerhalb der Öffnungen 11, 12, 13 und 14 eine Platin-Schicht 15, vorzugsweise durch Verdampfen oder Kathodenzerstäubung, bis zu einer Dicke von 40 nm aufgetragen. Die in der Öffnung 13 liegende Silicium-Schicht 9 verhindert, daß das Platin in dieser Öffnung mit dem Substrat in Berührung kommt.

In der Teil-Fig. 1B wird das Halbleiterplättchen dan für etwa 20 Minuten bei einer Temperatur von 550°C in einer Stickstoffatmosphäre gesintert, wodurch das Platin mit dem Silicium reagiert und in den Öffnungen 12, 13 und 14 Platin-Silicid-Schichten 15′ bildet. Das nicht umgesetzte Platin, einschließlich der über der Siliciumdioxid-Schicht 10 liegenden Platin-Schicht wird dann durch Ätzen mit Königswasser entfernt. Bekanntlich können auch andere Metalle, wie Palladium, Nickel oder Hafnium anstelle von Platin verwendet werden. Im nächsten Verfahrensschritt gemäß Teil-Fig. 1C wird der in der Öffnung 13 liegende Teil der Siliciumdioxid-Schicht 9 durch ein nasses oder trockenes Ätzverfahren entfernt, wodurch dieser Teil des Substrats freigelegt wird, welcher dann die Anode einer Schottky-Sperrschichtdiode mit niedriger Potentialschwelle bilden soll.

Das Niederschlagen des neuen Metallisierungssystems wird dann in den Öffnungen 11 bis 14 vorgenommen. Das bevorzugte Ablöseverfahren ist in der der Anmelderin gehörenden US-Patentschrift 4 004 044 eingehend beschrieben. Dieses Verfahren soll in abgekürzter Form anhand der Teil-Fign. 1D—1F beschrieben werden. Andere Verfahren zum Bilden der Metallisierung sind nasse oder reaktive Ionen- (Plasma-) Ätzverfahren, die dem Fachmann allgemein zugängig sind. Das Ablöseverfahren gestattet jedoch eine wesentlich bessere Definition der Metallisierung, wodurch die für die Verdrahtung erforderliche Fläche wesentlich herabgesetzt wird.

Gemäß der Teil-Fig. 1D wird nunmehr, alles überdeckend, eine dünne Schicht aus Polyäthersulphon aufgebracht, die das Ablöseverfahren erleichtert. Die Verwendung von Polyäthersulphon oder kurz Polysulphon ist eine Abänderung des in dem oben genannten Patent erwähnten Verfahrens und wurde in IBM Technical Disclosure Bulletin, Band 19, Nr. 4, vom September 1976, auf Seite 1226 beschrieben. Über der Polysulphon-Schicht 20 wird eine Schicht 22 aus einem organischen Polymeren aufgebracht, wie zum Beispiel auf Novalak-Harz-Basis aufgebauter positiver Photolack, der anschließend bei 210—230°C gebrannt oder gehärtet wird, so daß der Photolack nicht mehr photoempfindlich ist. Über der Photolackschicht 22 wird eine aus einem Methyl-Siloxan-Harz bestehende Sperrschicht 24 aufgebracht und anschließend eine Schicht 26 aus einem strahlungsempfindlichen Photolack.

Die Photolackschicht 26 wird dann zur Erstellung eines reliefartigen Musters entsprechend den Öffnungen 11, 12, 13 und 14 in der Teil-Fig. 1C belichtet und entwickelt. Die Photolackmaske 26 wird dan für die selektive Entfernung der darunter liegungen Schichten 20, 22 und 24 zum Freilegen der Öffnungen 11′, 12′, 13′ und 14′ in der Teil-Fig. 1D verwendet, die den in Teil-Fig. 1C gezeigten Öffnungen entsprechen.

Nach Herstellen der Öffnungen wird das freiliegende Substrat einschließlich der Platin-Silicid-Schicht 15 der erfindungsgemäßen Vorreinigung unter genau überwachten Strahlungsbedingungen mit einer Mischung 15:1 oder weniger von Wasser und Flußsäure-Ätzmitteln unterzogen. Ein Mischungsverhältnis von 5:1 ist am vorteilhaftesten. Der Ausdruck "Genau überwachte Strahlungsbedingungen" soll bedeuten, daß während dieses Ätzverfahrensschrittes Keine merkliche Lichtmenge mit einer Wellenlänge kürzer als 500 nm vorhanden sein darf. Durch diese vorbereitenden Verfahrensschritte wird in dem Kontaktbereich die Bildung einer aus amorphem Silicium bestehenden Schicht verhindert, die sich sonst sehr nachteilig auswirken könnte, da sie die Potentialschwelle erhöht. Diese Vorbereitung der Silicium-Oberfläche ist zur Erzielung einer Schottky - Sperrschichtdiode mit niedriger Potentialschwelle von etwa 0.5 Volt erforderlich. Die Anmelderin hat versucht, die Oberfläche gemäß üblicher Verfahren mit chemischen Ätzmitteln unter weißem Licht zu reinigen. Mit diesem bekannten Verfahren war es jedoch nicht möglich, eine so niedrige Potentialschwelle zu erzielen, man hat vielmehr nur eine Potentialschwelle von etwa 0.61 eV erreicht. Die Anmelderin hat außerdem versucht, die Halbleiteroberfläche in situ in einer Zerstäubungskammer durch Kathodenzerstäubung zu reinigen. Dieses Verfahren ergab zwar eine Potentialschwelle von etwa 0.5 eV, jedoch war der Idealitätsfaktor mit 1.15 zu hoch. Außerdem ließ sich diese Potentialschwelle exakt nicht wiederholen.

Gemäß Teil-Fig. 1E wird, alles überdeckend, eine aus Tantal bestehende Schicht 28 über dem Substrat und der Ablösemaske aufgebracht. Damit tatsächlich ein Schottky-Sperrschichtkontakt mit niedriger Potentialschwelle erzielt werden kann, muß dieser Niederschlag der Tantal-Schicht ebenfalls mit einem sehr sorgfältig durchgeführten Verfahren erfolgen. Der Niederschlag erfolgt am besten mit einer Electronenstrahl - Verdampfungsquelle. Der

höchste in der Verdampfungskammer herrschende Druck beträgt während des Verfahrens $3.333 \times 10^{-6}$mbar, wobei der Anfangsdruck in der Kammer weniger als $5.333 \times 10^{-7}$mbar ist. Die Maximaltemperatur des Substrats beträgt 200°C. Der hier angegebene Druckes ist für die Menge der in der Kammer vorhandenen Feuchtigkeit, Kohlenwasserstoffe und anderer gasförmiger Verunreinigungen von Bedeutung. Je höher der Druck, umso höher die Feuchtigkeit und der Anteil an Verunreinigungen, die eine leichte Oxidation der Tantal-Schicht hervorrufen können, so daß sich eine Potentialschwelle von etwas mehr als 0.5 eV ergibt. Wenn eine Potentialschwelle dieser Größe annehmbar ist, dann ist der Druck in der Kammer von geringerer Bedeutung und man könnte übliche Verfahren einsetzen. Das Niederschlagsverfahren, das mit einer Geschwindigkeit von etwa 0.2 nm je Sekunde abläuft, wird fortgesetzt, bis eine Schichtdicke von $60 \pm 15$ nm erreicht ist. Die unter diesen Bedingungen erzeugte Tantal-Schicht besteht aus kubischraumzentrierten Kristallen.

Statt durch Elektronenstrahl verdampfung kann Tantal auch unter gleichen Druck- und Temperaturbedingungen durch Hochfrequenzzerstäubung aufgebracht werden. Gleichspannungszerstäubung ist nicht geeignet, da bei Gleichspannungszerstäubung aufgebrachte Tantal-Schichten aus raumzentrierten tetragonalen Kristallen bestehen, während durch Hochfrequenz zerstäubtes Tantal sich als kubisch-raumzentrierte Kristalle niederschlägt.

Nach der Verdampfung der Tantal-Schicht 28 wird eine Schicht 30 aus Chrom und eine Schicht 32 aus Aluminium oder aus mit Kupfer dotiertem Aluminium bzw. mit Kupfer dotiertem Aluminium-Silicium, vorzugsweise in der gleichen Verdampfungskammer niedergeschlagen.

Die Chrom-Schicht wird vorzugsweise bis zu einer Dicke von 60—100 nm niedergeschlagen. Während dieses Verdampfungsvorgangs muß Wasserdampf in die Kammer eingeleitet werden. Das Substrat wird dabei auf einer Maximaltemperatur von 160°C gehalten, wobei dem Substrat keinerlei Wärme zugeführt wird. In dem Verfahren wird eine geringe Menge Chrom in das Schiffchen eingebracht und Wasserdampf wird in die Verdampfungskammer eingeleitet, deren Druck bei etwa $1.333 \times 10^{-5}$mbar gehalten wird.

Bei Erwärmung durch einen Elektronenstrahl wird das reine Chrom in dem Schiffchen verdampft und zu handelsüblichem Chrom umgewandelt, was für die Bildung der Sperrschicht kritisch ist. Das mit Wasserdampfzufuhr niedergeschlagene Chrom weist an den Korngrenzen Chromoxid auf. Wir haben festgestellt, daß reines Chrom, d.h. elementares Chrom als Sperrschicht zwischen Aluminium und Tantal wirkungslos ist.

Das Aluminium wird vorzugsweise bis zu einer Schichtdicke von 850—1000 nm niedergeschlagen. Ein mit einer geringen Menge Kupfer dotiertes Aluminium ist reinem Aluminium vorzuziehen. Es soll hier der Ausdruck Aluminium in der Weise verwendet werden, daß auch mit Kupfer dotiertes Aluminium und auch mit Kupfer dotiertes Aluminium-Silicium darunter verstanden werden soll. Die sich dabei ergebende Struktur zeigt Teil-Fig. 1E.

Die verbleibende Ablösestruktur und die darüberliegende Metallschicht werden unter Verwendung von N-Methylpyrrolidon oder einem anderen geeigneten Lösungsmittel rasch abgehoben, so daß ein metallisches Muster auf der Oberfläche des Substrats oder der Oxidschicht 10 verbleibt, wie dies Teil-Fig. 1F zeigt.

Dann wird diese Struktur für etwa 1 Stunde bei 400°C und dann erneut für weitere 2 Stunden bei 450°C gesintert. Dieser Sinter-Verfahrenschritt ist wichtig, da er die Grenzflächen-Ladungen und Filme zwischen Silicium-Substrat und dem tantal zumindest verringert, meist aber beseitigt. Obgleich diese Zeiten und Temperaturangaben am vorteilhaftesten sind, können auch andere Werte durch normale Versuche ermittelt werden, die ebenso wirksam sein mögen. Diese Sinterung ist erforderlich, um die Höhe der Potentialschwelle von 0.5 eV zu erzielen, selbst dann, wenn nur Tantal als Kontaktmaterial, d.h. ohne Chrom und Aluminium verwendet worden wäre.

Damit ist das Grundverfahren beendet, und man hat Schottky-Sperrschichtdioden mit hoher Potentialschwelle und mit niedriger Potentialschwelle. Die Anode und die Kathode der Schottky-Sperrschichtdiode mit hoher Potentialschwelle sind durch die Bezugszeichen 34 bzw. 35 in Teil-Fig. 1F bezeichnet. Anode und Kathode der Schottky-sperrschichtdiode mit niedriger Potentialschwelle sind durch die Bezugszeichen 36 bzw. 37 bezeichnet.

Unter Verwendung der gleichen Metallisierung wurden drei verschiedene Arten von Kontakten hergestellt. Die Kathoden beider Dioden sind die nach den $N^+$-leitenden Zonen 5 und 7 in der Schicht 3 führenden ohmschen Kontakte. Die Anode 34 der Schottky-Sperrschichtdiode mit hoher Potentialschwelle verwendet eine Chrom-Tantal-Metallisierung zwischen der Platin-Silicid-Schicht 15 und der Aluminium-Schicht 32, welche als Diffusionssperre wirkt, während die Platin-Silicid-Schicht eine erhöhte Potentialschwelle ergibt, verglichen mit der Anode 36 der Schottky-Sperrschichtdiode mit niedriger Potentialschwelle, wo keine Platin-Silicid-Schicht vorhanden ist.

In der Zone 36 berührt die Tantal-Schicht das N-leitende Silicium-Substrat 3 unmittelbar.

In der Praxis ist bei der Herstellung einer Schottky-Sperrschichtdiode mit hoher Potentialschwelle die Tantal-Schicht nicht erforderlich. Ein aus Aluminium, Chrom und Platin-Silicid bestehender Kontakt ist völlig zufriedenstellend. Es ist jedoch bei der praktischen Herstellung wesentlich besser, das Tantal, alles überdeckend, innerhalb aller

Kontaktöffnungen niederzuschlagen.

Es wurde dabei festgestellt, daß die Chrom-Schicht 30 insofern kritisch ist, da sie als Sperrschicht eine Wechselwirkung zwischen Aluminium und Tantal verhindert. Es ist allgemein bekannt, daß Aluminium in einer unzuträglichen Weise mit Silicium reagiert und auch Platin-Silicid für eine Wechselwirkung oder Reaktion mit Silicium durchdringt. Entgegen allen Erwartungen reagieren Tantal und Aluminium jedoch miteinander in der Weise, daß beim Sintern ein Film hoher Widerstandsfähigkeit gebildet wird. Es ist daher notwendig, zwischen der Aluminium- und der Tantal-Schicht eine aus Chrom bestehende Sperrschicht vorzusehen. Das hat zur Folge, daß der Serienwiderstand stark verringert wird und von etwa 1 Megohm auf etwa 100 ohm zurückgeht. Es wurde ferner festgestellt, daß Platin als Sperrschicht zwischen Aluminium und Tantal nicht geeignet ist, weil Platin mit Aluminium reagiert, was zur Folge hat, daß das Aluminium in das Tantal eindringt.

Die kritische Natur der zwischen Tantal und Aluminium liegenden aus Chrom bestehenden Sperrschicht wird sehr schön deutlich aus Fig. 2. Die Diagramme zeigen in Prozenten die Veränderung der Durchlaßspannung (ΔVF%) über der Zeit für eine Schottky-Sperrschichtdiode mit einer zusammengesetzten Schicht aus Tantal und mit Kupfer dotiertem Aluminium, im Vergleich mit einer zusammengesetzten Schicht aus Tantal, Chrom und mit Kupfer dotiertem Aluminium. Man sieht, daß die letztgenannte Metallisierung vier- bis sechsmal stabiler ist, als die erstgenannte.

Fig. 3 zeigt ein Diagramm der gemessenen Stromspannungskennlinie in Durchlaßrichtung, IF über VF, von erfindungsgemäß auf dem gleichen Halbleiterplättchen aufgebauten Schottky-Sperrschichtdioden mit hoher bzw. niedriger Potentialschwelle. Die Anodenflächen beider Schottky-Sperrschichtdioden sind die gleichen. Die Potentialschwelle $\Phi_B$ der Schottky-Sperrschichtdiode mit niedriger Potentialschwelle beträgt angenähert 0.5 eV. Der Idealitätsfaktor $\eta$ ist angenähert 1.10.

Die Potentialschwelle $\Phi_B$ der Schottky-Sperrschichtdiode mit hoher Potentialschwelle liegt bei angenährt 0.8 eV. Der Idealitätsfaktor $\eta$ beträgt angenähert 1.06.

Wie bereits erwähnt, ist die Erfindung insbesondere für integrierte Schaltungen von Vorteil, bei der Schottky-Sperrschichtdioden mit niedriger Potentialschwelle erforderlich sind. Eine solche in Fig. 4 dargestellte Schaltung ist eine DTL-Schaltung gemäß dem Stande der Technik, die ein NAND-Glied darstellt. Diese Schaltung bildet keinen Teil der Erfindung an sich und ist dem Fachmann aus der Halbleiterschaltungstechnik gut bekannt. Es sei hier angemerkt, daß die Erfindung in keiner Weise auf diese bestimmte Schaltung oder auf die Anordnung auf einem Halbleiterplättchen beschränkt ist. Vielmehr ist die Erfindung auf verschiedene Schaltungssysteme, wie zum Beispiel TTL, Standard DTL usw. anwendbar.

Diese Art von Schaltung und ihre Abwandlungen sind in einem Aufsatz von Peltier mit dem Titel "A New Approach to Bipolar SLI: $C^3L$" in 1975 IEEE International Solid-State Circuits Conference, Digest of Technical Papers, Seiten 168—169 beschrieben. Die Schaltung enthält einen einzigen Transistor T1 mit zwei Vorspannungswiderständen, die mit RB bzw. RC bezeichnet sind, und an Basis bzw. Kollektor des Transistors T1 angeschlossen sind, und aus einer als Haltediode wirkenden Schottky-Sperrschichtdiode DO mit hoher Potentialschwelle. Die Schaltung hat sechs anschließbare Ausgänge, in Form von Schottky-Sperrschichtdioden D1, D2, D3, D4, D5 und D6 mit niedriger Potentialschwelle und einen ohmschen Kontakt an der Kollektorelektrode, der mit C bezeichnet ist.

Fig. 5 zeigt eine Querschnittsansicht einer DTL-Zelle. Jede dieser Zellen ist in gleicher Form auf einem Halbleiterplättchen mehrere hundert mal vorhanden, wie dies dem Fachmann der Halbleitertechnik bekannt ist.

Transistor T1 besteht aus einer langgestreckten Subkollektorzone 104, einer Basiszone 123 und einer Emitterzone 124. Die Schottky-Sperrschichtdioden D1, D2 ... D6 sind symmetrisch auf jeder Seite des Transistors T1 in der Epitaxialschicht 103 angeordnet. Der Kollektorkontakt C vervollständigt den Transistor T1. Die Widerstände RB und RC sind nicht gezeigt. Wie in Fig. 5 dargestellt, weisen nur diejenigen Dioden, die tatsächlich in die Schaltung eingeschaltet sind, die zur Darstellung dieser Dioden erforderliche neuartige Metallisierung auf. Daher ist die Anzahl der tatsächlich verwendeten, mit Störelementen dotierten Zonen kleiner als die maximale Anzahl der möglichen Dioden, und die Orte der nicht benutzten Dioden D2 und D6 sind in gestrichelten Linien gezeigt.

Die Dioden D1, D3, D4 und D5 sind erfindungsgemäß aufgebaute Schottky-Sperrschichtdioden mit niedriger Potentialschwelle. Sie bestehen aus N-leitendem Silicium 103, einer Tantal-Schicht 128, einer Chrom-Schicht 130 und einer Aluminium-Kupfer-Verbindungsmetallisierung 132 für ein $\Phi_B$ von angenähert 0.5 eV. Die Haltediode DO enthält ebenfalls eine Platin-Silicid-Schicht 115 und liefert ein $\Phi_B$ von angenähert 0.8 eV.

Als Alternative zu dem bei der Herstellung des Metallisierungsmusters verwendeten Ablöseverfahrens kann auch subtraktives oder reaktives Ionen- (Plasma) oder chemisches Ätzen eingesetzt werden. Dieselben kritischen Verfahrensschritte der Vorreinigung, die Betriebsbedingungen der Vakuumkammer und der Sinterung müssen eingehalten werden. Wie bereits erwähnt, sind diese Verfahren nicht so vorteilhaft wie das Ablöseverfahren.

Bei jedem dieser Ätzverfahren werden alles überdeckende Schichten aus Tantal, Chrom und

Kupfer dotierten Aluminium oder Kupfer dotiertem Aluminium-Silicium in den Öffnungen 11, 12, 13 und 14 in Fig. 1 niedergeschlagen. Ein positives Muster wird durch einen positiven Photolack definiert.

Die nun freiliegenden, nicht benötigten Metallschichten werden durch übliche, nasse Ätzverfahren für Metalle in einem subtraktiven Verfahren oder dadurch entfernt, daß man das Substrat in eine Plasma-Ätzkammer einbringt, das für ein Plasma-Ätzverfahren eine Gasmischung aus $CCl_4$—Ar enthält.

Bei dem chemischen Ätzverfahren wird das freiliegende Aluminium durch eine Mischung aus

$$H_3PO_4—HNO_3—H_2O$$

entfernt. Die freiliegende Chrom-Oberfläche wird durch eine Mischung aus 50 Gramm $KMnO_4$ und einem Liter eines Entwicklers entfernt. Dann wird das Tantal durch Zerstäubungsätzen entfernt, wobei die restliche, Aluminium-Schicht als Maske dient. Ist die Breite der Metallisierungs-Leitungszüge des Musters größer als 0.0127 mm, dann kann das Tantal durch eine Mischung aus einem Teil HF, 20 Teilen $HNO_3$ und 20 Teilen $H_2O$ entfernt werden.

**Patentansprüche**

1. Verfahren zum Herstellen von Tantal-Kontakten auf einem aus N-leitendem Silicium bestehenden Halbleitersubstrat, insbesondere zur Bildung von Schottky-Sperrschichtkontakten mit niedriger Potentialschwelle, durch Niederschlagen einer Tantalschicht unter vorgegebenen Bedingungen auf einem zuvor durch Ätzung gereinigten Teil der Oberfläche des Substrats, mittels Elektronenstrahlverdampfung oder Hochfrequenz-Kathodenzerstäubung bei niedrigem Druck und niedriger Temperatur zur Vermeidung einer Oxidation des Tantals und Sinterung des Substrats für eine solche Zeit und bei einer solchen Temperatur, daß dabei die zwischen Substratoberfläche und Tantalschicht vorhandenen Grenzflächenladungen entfernt werden, und durch Niederschlagen einer Chromschicht über der Tantalschicht und einer Aluminiumschicht über der Chromschicht, wobei das aus der Schichtenfolge Tantal-Chrom-Aluminium bestehende Muster durch ein Ablöseverfahren definiert wird, dadurch gekennzeichnet, daß die Reinigung der Oberfläche des Siliciumsubstrats mit einer verdünnten Flußsäure-Ätzlösung unter solchen Arbeitsbedingungen durchgeführt wird, daß dabei kein Licht mit einer Wellenlänge von weniger als 500 nm auftritt, daß dann die Tantalschicht durch Ekektronenstrahlverdampfung im Vakuum bei einem Verdampfungsdruck von höchstens $3{,}333 \times 10^{-6}$ mbar bei einem Anfangs-Verdampfungsdruck von weniger als $5{,}333 \times 10^{-7}$ mbar und einer Substrattemperatur von höchstens 200°C aufgebracht wird, und daß während der Verdampfung des Chroms Wasserdampf in die Verdampfungskammer eingeleitet wird, um an den Korngrenzen Chromoxid zu bilden.

2. Verfahren nach Anspruch 1, dadurch gekennzeichnet, daß ein N-leitendes Siliciumsubstrat mit einer Störelementkonzentration von $1 \times 10^{16}$ bis $8 \times 10^{16}$ Atome/$cm^3$ verwendet wird.

3. Verfahren nach Anspruch 1 zum Herstellen von ohmschen Tantal-Kontakten, dadurch gekennzeichnet, dab auf durch Öffnungen (11, 12, 14) in einer Maskierungsschicht (9, 10) vorher bestimmbaren Teilen der gereinigten Oberfläche des Siliciumsubstrats vor dem Niederschlagen der Tantalschicht eine metallisches Silicid gebildet wird.

**Claims**

1. Method of fabricating tantalum contacts on a semiconductor substrate consisting of N-type silicon, in particular for forming Schottky barrier contacts with a low potential threshold, by vapour depositing a tantalum layer under predetermined conditions on a part of the substrate surface previously cleaned by etching, using electron beam evaporation or highfrequency cathode sputtering at a low pressure and a low temperature to avoid oxidation of the tantalum, sintering the substrate for such time and at such temperature that interfacial charges existing between substrate surface and tantalum layer are removed, and depositing a chromium layer on top of the tantalum layer and an aluminium layer on top of the chromium layer, wherein the pattern consisting of the layer sequence tantalum-chromium-aluminium is defined by a lift-off process, characterized in that the surface of the silicon substrate is cleaned in a dilute hydrofluoric acid etching solution under conditions in which there is no light of a wavelength shorter than 500 nm, that subsequently the tantalum layer is applied by electron beam evaporation in a vacuum at an evaporation pressure not exceeding $3.333 \times 10^{-6}$ mbar at an initial evaporation pressure of less than $5.333 \times 10^{-7}$ mbar and at a substrate temperature not exceeding 200°C, and that during the evaporation of the chromium water vapour is introduced into the evaporation chamber to form chromium oxide at the grain boundaries.

2. Method in accordance with claim 1, characterized in that an N-type silicon substrate with an impurity concentration from $1 \times 10^{16}$ to $8 \times 10^{16}$ atoms/$cm^3$ is used.

3. Method in accordance with claim 1 for fabricating ohmic tantalum contacts, characterized in that on parts of the cleaned surface of the silicon substrate, predeterminable by openings (11, 12, 24) in a masking layer (9, 10),

a metallic silicide is formed prior to the deposition of the tantalum layer.

## Revendications

1. Procédé de fabrication de contacts de tantale sur un subbstrat semi-conducteur formé de silicium de type N, et plus particulièrement de contacts à barrière de Schottky à seuil de faible potentiel, par dépôt en phase vapeur d'une couche de tantale dans des conditons prédéterminées sur une partie de la surface du substrat préalablement nettoyée par décapage, par évaporation par faisceau électronique ou pulvérisation cathodique à haute fréquence, à basse pression et basse température pour éviter l'oxydation du tantale et le frittage du substrat pendant ce temps et à cette température, de façon que pendant ce procédé, les charges interfaciales existant entre la surface du substrat de la couche de tantale soient retirées, et par dépôt d'une couche de chrome par dessus la couche de tantale et d'une couche d'aluminium par dessus la couche de chrome, ce qui fait que la configuration formée par la séquence des couches tantale-chrome-aluminium est définie par un procédé d'élimination par soulèvement, caractérisé en ce que:
la surface du substrat de silicium est nettoyée dans une solution de décapage d'acide fluorhydrique dilué dans des conditions où aucune lumière dont la longueur d'onde est inférieure à 500 nm, n'est présente,
la couche de tantale est alors appliquée par évaporation par faisceau électronique sous vide à une pression d'évaporation n'excédant pas $3{,}333 \times 10^{-6}$ millibars à une pression d'évaporation initiale inferieure à $5{,}333 \times 10^{-7}$ millibars et à une température de substrat ne dépassant pas 200°C et en ce que, pendant l'évaporation du chrome, de la vapeur d'eau est introduite dans la chambre d'évaporation pour former de l'oxyde de chrome aux limites des grains.

2. Procédé selon la revendication 1, caractérisé en ce qu'un substrat de silicium de type N avec une concentration d'impureté de $1 \times 10^{16}$ à $8 \times 10^{16}$ atomes/cm$^3$, est utilisé.

3. Procédé selon la revendication 1 pour la fabrication de contacts de tantale ohmique, caractérisé en ce que:
un siliciure métallique est formé avant le dépôt de la couche de tantale, sur des parties de la surface nettoyée du substrat de silicium, prédéterminées par des ouvertures (11, 12, 24) ménagées dans une couche de masquage (9, 10).

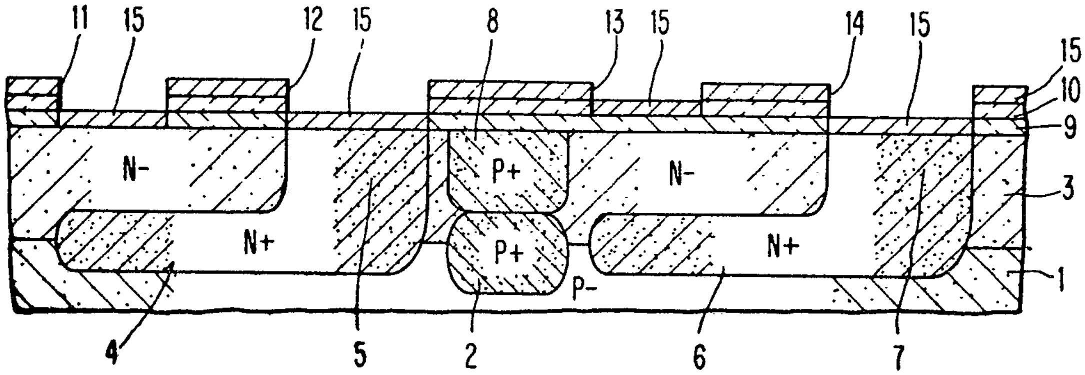


FIG. 1A

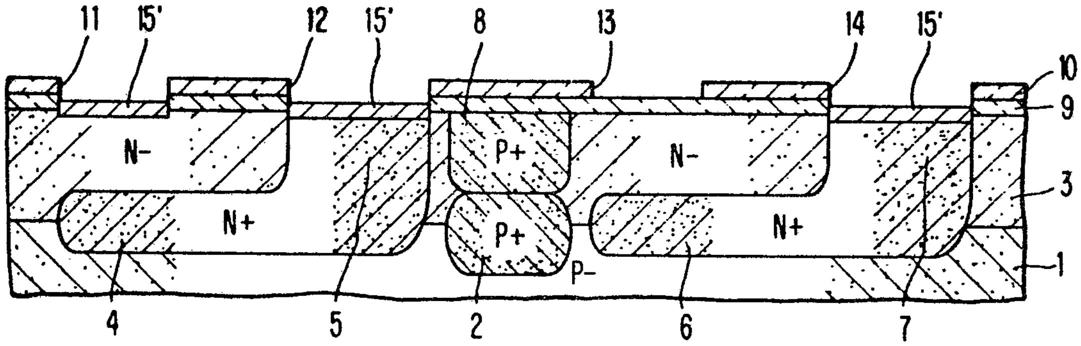


FIG. 1B

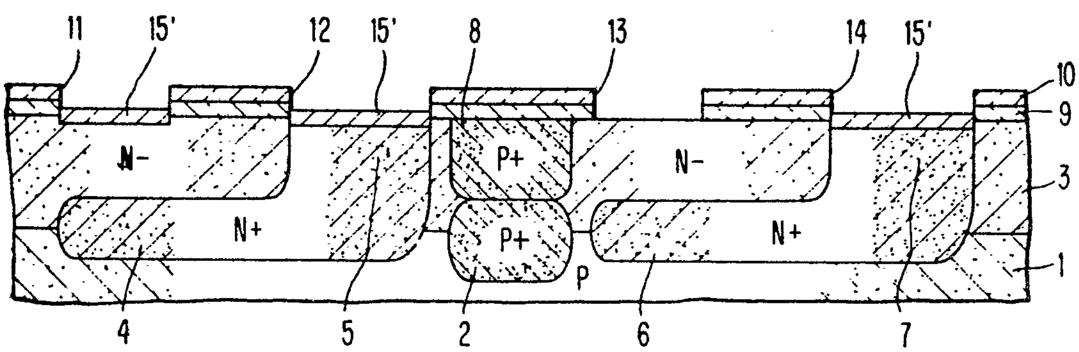


FIG. 1C

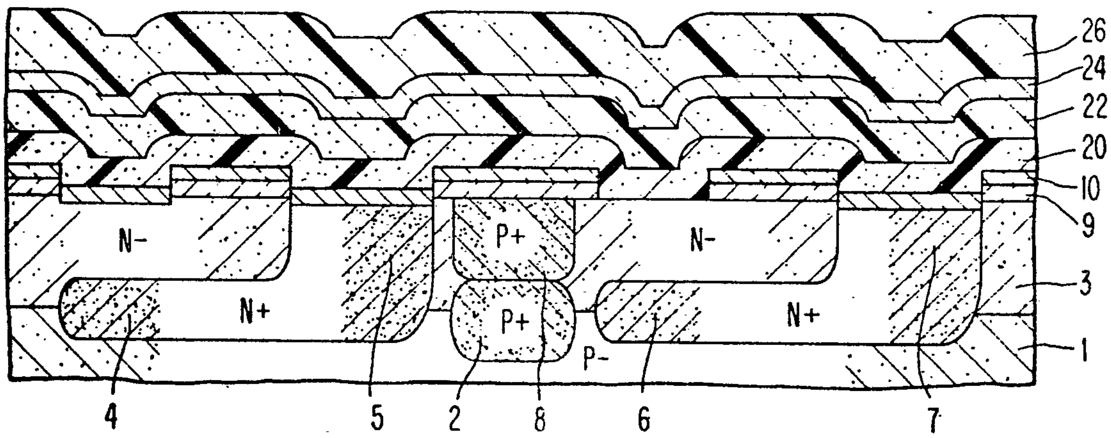


FIG. 1 D

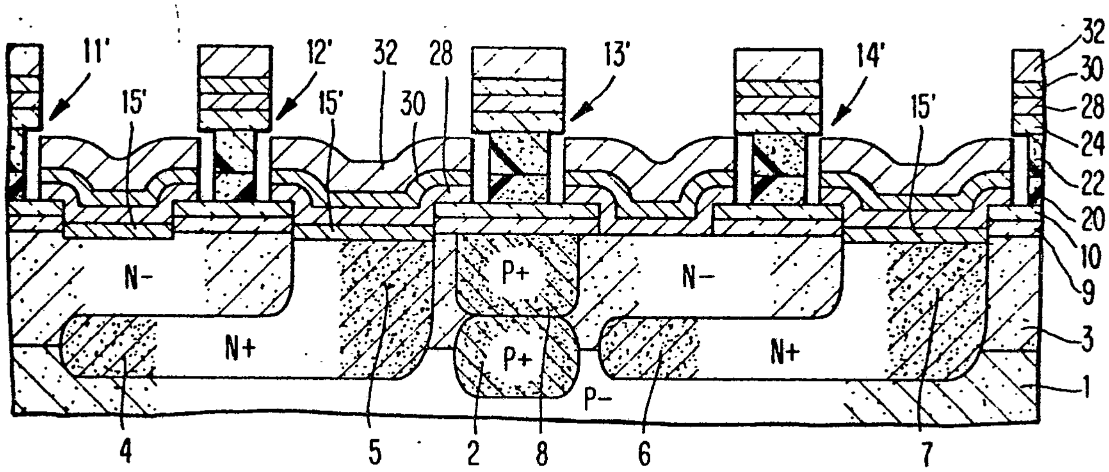


FIG. 1 E

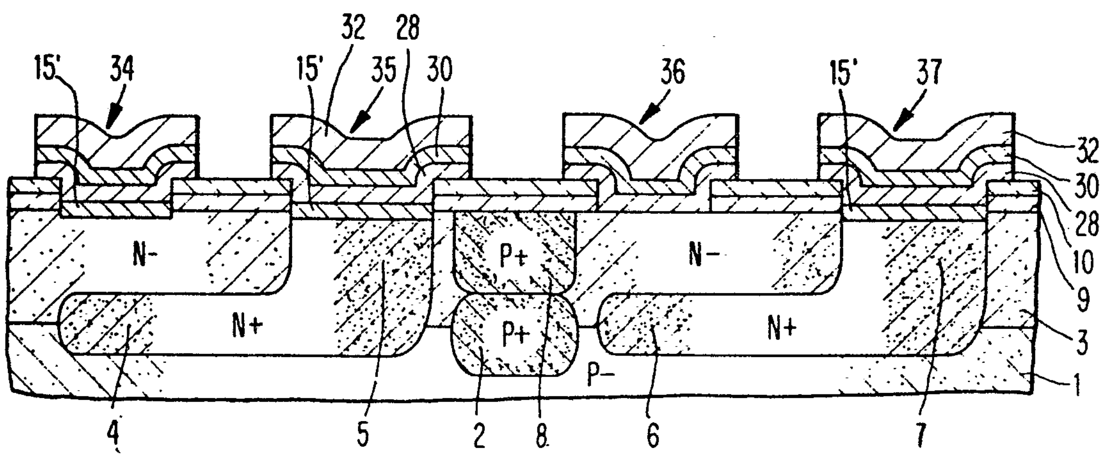


FIG. 1 F

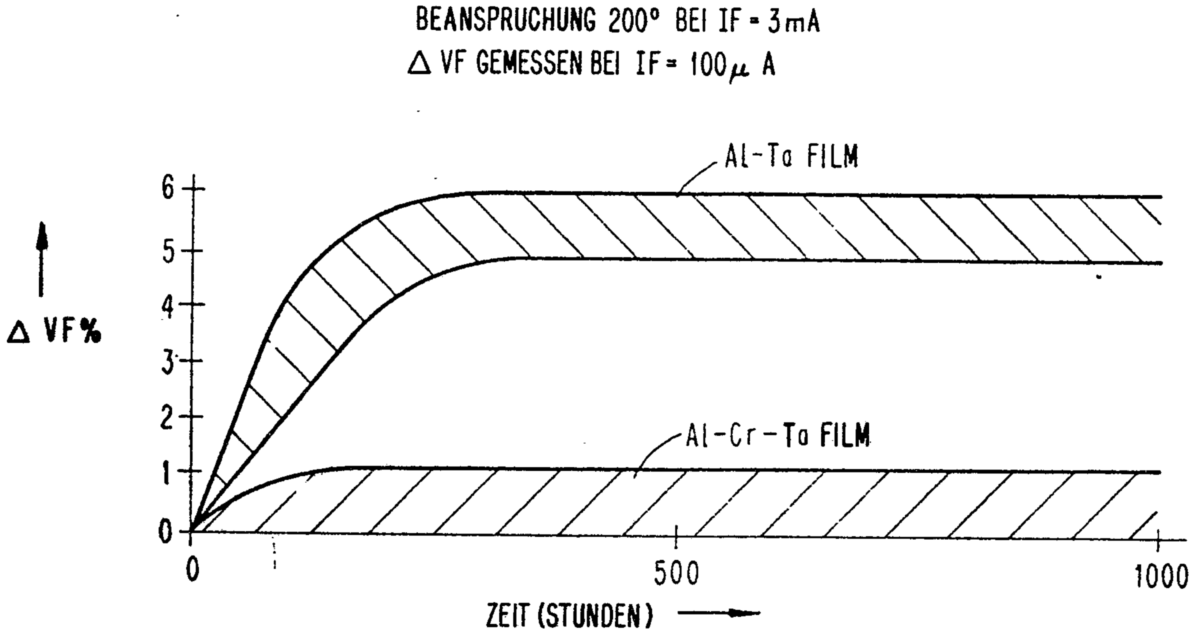
BEANSPRUCHUNG 200° BEI IF = 3mA
Δ VF GEMESSEN BEI IF = 100μ A
Al-Ta FILM
Al-Cr-Ta FILM
Δ VF%
6
5
4
3
2
1
0
0
500
1000
ZEIT (STUNDEN)

FIG. 2

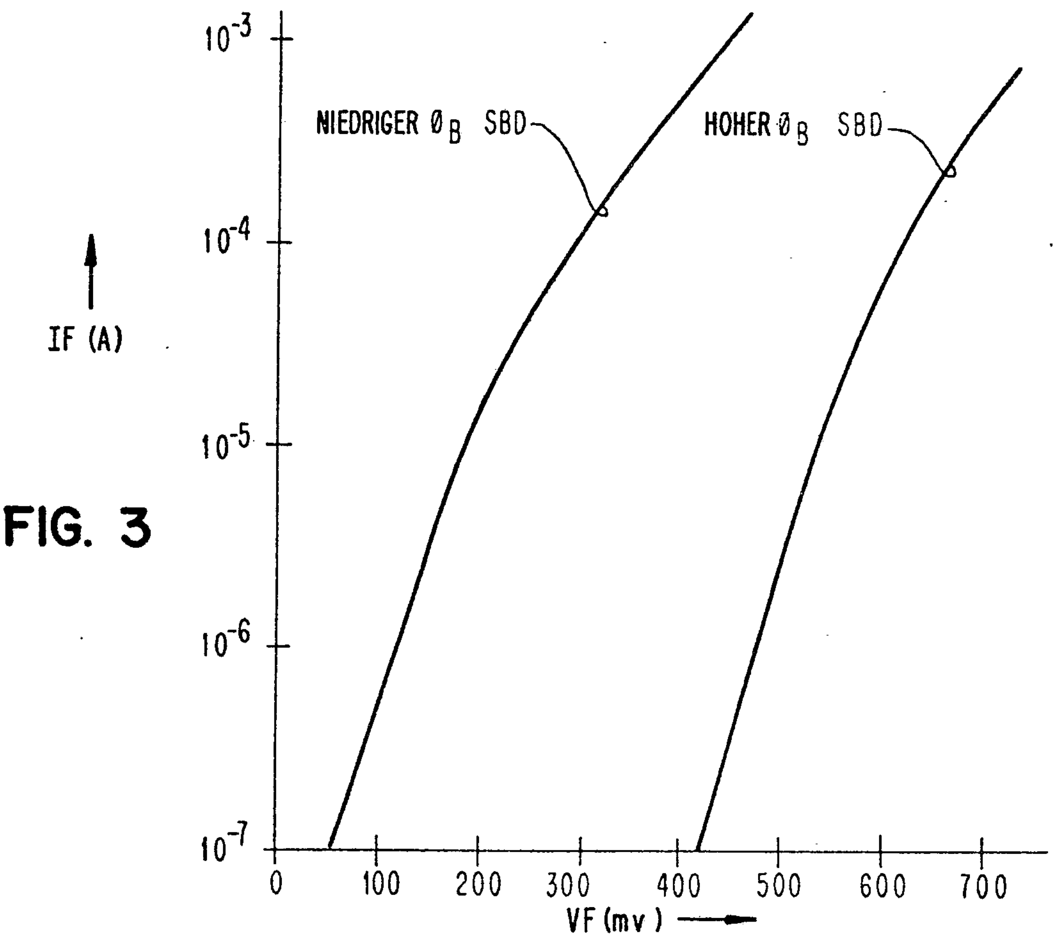
NIEDRIGER ØB SBD
HOHER ØB SBD
IF (A)
10^-3
10^-4
10^-5
10^-6
10^-7
0
100
200
300
400
500
600
700
VF (mv)

FIG. 3

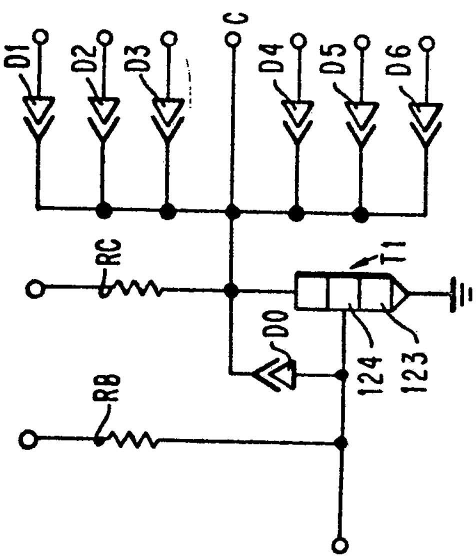
D1
D2
D3
C
D4
D5
D6
RC
T1
D0
124
123
RB

FIG. 4

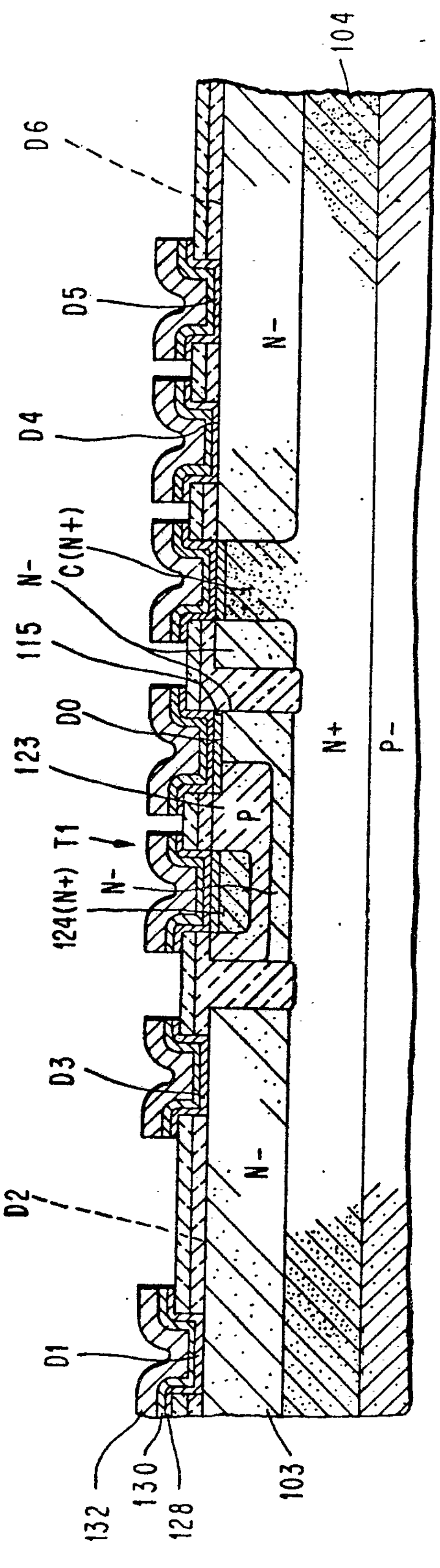
104
D6
D5
N-
D4
N-
C(N+)
115
D0
123
N+
P-
P
124(N+) T1
N-
D3
N-
D2
D1
132
130
128
103

FIG. 5